# EUROPEAN PATENT SPECIFICATION

(11) **EP 2 674 514 B1**
(45) Date of publication and mention of the grant of the patent: **05.09.2018**
(21) Application number: 11863888.1
(22) Date of filing: 13.05.2011
(51) Int. Cl.: C23C 28/00, C23C 14/40, C23C 14/06, C23C 14/02, F02M 61/18

(54) **STRUCTURE AND METHOD FOR COATING A NOZZLE FOR A FUEL INJECTION VALVE**
STRUKTUR UND VERFAHREN ZUR BESCHICHTUNG EINER DÜSE FÜR EINE KRAFTSTOFFEINSPRITZDÜSE
STRUCTURE ET PROCÉDÉ D'ENROBAGE D'UN INJECTEUR DESTINÉ À UNE SOUPAPE D'INJECTION DE CARBURANT

(30) Priority: 19.04.2011 KR 20110036365
(43) Date of publication of application: 18.12.2013
(73) Proprietor: Kefico Corporation, Gyeonggi-do 435-716 (KR)
(72) Inventor: SHIN, Moon Sung, Gunpo-si Gyeonggi-do 435-738 (KR); KANG, Kyeong Kyun, Seoul 150-935 (KR); KIM, Hyoung Jin, Gunpo-si Gyeinggi-do 435-776 (KR)
(74) Representative: Zimmermann, Tankred Klaus
(86) International application number: PCT/KR2011/003532
(87) International publication number: WO 2012/144682

(56) References cited:
- KR-A- 20070 016 818
- KR-A- 20090 126 966
- KR-B1- 100 643 617
- KR-B1- 100 798 807
- US-A1- 2009 302 136
- US-B1- 6 715 693

## Description

### TECHNICAL FIELD

Exemplary embodiments of the present invention relate to a nozzle of a fuel injection valve, and more particularly, to a nozzle coating structure and method of a fuel injection valve capable of forming a coating layer on a nozzle of a fuel injection valve for injecting and supplying a fuel into a cylinder of an internal combustion engine so as to improve the hardness of the nozzle, thereby enhancing the impact resistance of the nozzle.

### BACKGROUND ART

A fuel injection valve for injecting and supplying a fuel into an internal combustion engine is constituted so as to start a fuel injection by eliminating a back pressure of a valve piston through an electronic actuator and moving a nozzle needle, and to complete the fuel injection by applying a predetermined back pressure to the valve piston through the electronic actuator and moving the nozzle needle in the opposite direction after the elapse of a predetermined time.

As such, the start and completion of the fuel injection are performed in such a manner as to close or open an injection hole of a nozzle body with the nozzle needle by controlling the back pressure of the valve piston. Accordingly, there is a problem in that the nozzle needle and the nozzle body are worn out due to repeated collisions between the nozzle needle and the nozzle body, thereby causing a change in fuel injection characteristics of the fuel injection valve as time elapses.

In order to solve this problem, the fuel injection valve of the related art is designed so that the abrasion of the nozzle needle is reduced and the deformation thereof is suppressed by manufacturing the nozzle needle with a material having a high hardness to enable stable fuel injection characteristics to be obtained for a long time.

However, even though the abrasion of the nozzle needle is reduced by an improvement in hardness thereof, an initial hardness of the nozzle body may not be maintained due to a reduction in hardness of the nozzle body colliding with the nozzle needle. Accordingly, the nozzle body is worn out due to repeated collisions between the nozzle needle and the nozzle body as a result of movement of the valve. Consequently, the abrasion of the nozzle body is progressed and a seating position of the nozzle needle is gradually changed. Thus, since the fuel injection characteristics are changed, there is a problem of being unable to obtain stable fuel injection characteristics for a long time.

US 6715693 B1 shows a fuel injector valve in which the needle is coated with a tungsten carbide containing carbon material and optionally a metallic chromium bond layer.

US 20090302136 A1 discloses a fuel injector valve in which the needle is coated with diamond-like carbon and the valve seat is coated with a layer sequence of a chromium layer followed by a chromium nitride layer and a tungsten carbide carbon layer (modular WCC).

### DETAILED DESCRIPTION OF THE INVENTION

### TECHNICAL PROBLEM

Accordingly, the present invention has been made in view of the above-mentioned problem, and a primary object thereof is to provide a nozzle coating structure and method of a fuel injection valve capable of preventing the abrasion of a nozzle needle according to a fuel injection operation of the fuel injection valve.

### TECHNICAL SOLUTION

In accordance with an aspect of the present invention, a nozzle coating structure of a fuel injection valve for reducing frictional resistance of a nozzle needle which comes into contact with a seat portion of a nozzle body formed with an injection hole includes a Cr coating layer deposited on an outer peripheral surface of the nozzle needle of the fuel injection valve; a CrN coating layer deposited on an outer peripheral surface of the Cr coating layer; and a WCC coating layer deposited on an outer peripheral surface of the CrN coating layer, wherein the CrN coating layer is formed to have a hardness relatively greater than a hardness of the WCC coating layer. Each of the Cr coating layer, the CrN coating layer and the WCC coating layer has soft magnetism in order for the fuel injection valve to be smoothly operated.

A total thickness of the Cr coating layer, the CrN coating layer, and the WCC coating layer may be formed between 1 µm to 5 µm.

The coating layers on the nozzle needle may be deposited by a sputtering process in a plasma state caused by an Ar gas.

After Cr particles, which are separated from a Cr target by a plasma, react with N particles, which are separated from an N₂ gas injected as an activated gas, and CrN particles are formed, the CrN particles may be deposited on a base material of the Cr coating layer to allow the CrN coating layer to be formed.

After WC particles, which are separated from a WC target by a plasma, react with C particles, which are separated from an acetylene (C₂H₂) gas injected as an activated gas, and WCC particles are formed, the WCC particles may be deposited on a base material of the CrN coating layer to allow the WCC coating layer to be formed.

In accordance with another aspect of the present invention, a nozzle coating method of a fuel injection valve for reducing frictional resistance of a nozzle needle which comes into contact with a seat portion of a nozzle body formed with an injection hole includes forming an inside of a chamber in a vacuum state so as to improve a reaction rate of a gas; forming the inside of the chamber in a plasma state by increasing a temperature of the chamber after injecting an Ar gas into the chamber; performing an etching process to remove an oxidized layer and impurities on a nozzle surface of the fuel injection valve; depositing a Cr coating layer on an outer peripheral surface of the nozzle needle of the fuel injection valve; depositing a CrN coating layer on an outer peripheral surface of the Cr coating layer; and depositing a WCC coating layer on an outer peripheral surface of the CrN coating layer, wherein the CrN coating layer is formed to have a hardness relatively greater than a hardness of the WCC coating layer. Each of the Cr coating layer, the CrN coating layer and the WCC coating layer has soft magnetism in order for the fuel injection valve to be smoothly operated.

The inside of the chamber entering the plasma state may be maintained in a temperature range of 200 to 280°C.

A bias voltage for forming the plasma state may be in a range of 200 to 400 V.

### BRIEF DESCRIPTION OF DRAWINGS

Fig. 1 is a cross-sectional view illustrating a nozzle structure of a fuel injection valve according to an embodiment of the present invention.
Figs. 2 and 3 are a view and a photograph schematically illustrating a nozzle coating structure of the fuel injection valve according to the embodiment of the present invention.

### BEST MODE FOR INVENTION

Reference will now be made in detail to embodiments of a nozzle coating structure and method of a fuel injection valve according to the present invention with reference to the accompanying drawings.

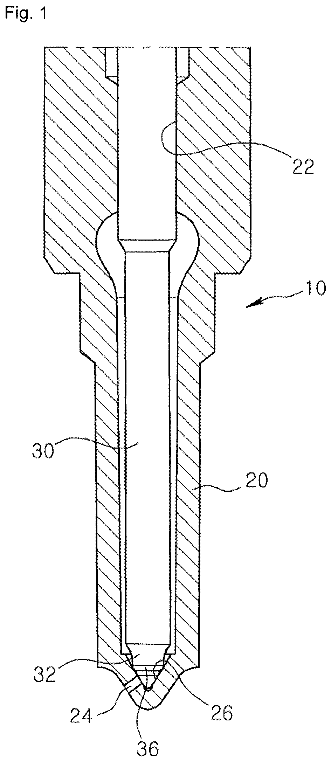

Fig. 1 illustrates a structure of a nozzle of a fuel injection valve according to an embodiment of the present invention.

The nozzle 10 of the fuel injection valve includes a nozzle body 20 and a nozzle needle 30. The nozzle needle 30 is housed within the nozzle body 20 so as to be supported and guided to be axially movable within the nozzle body 20 through an opening 22 which is formed in the nozzle body 20 on the same axis as the nozzle needle 30. A tip of the nozzle needle 30 is constituted to function as a valve body for opening and closing an injection hole 24.

Accordingly, when the nozzle needle 30 is at a position of closing the injection hole 24, no fuel is injected from the fuel injection valve. On the other hand, when the nozzle needle 30 moves back and is at a position of opening the injection hole 24, the fuel is injected from the fuel injection valve.

As such, when the fuel injection valve is changed to a closed state, a tip portion 32 of the nozzle needle 30 collides with a seat portion 26 formed in the vicinity of the injection hole 24 in the inside of the nozzle body 20. As such a collision is repeated for a long time, the seat portion 26 is slowly worn out to thereby change fuel injection characteristics of the fuel injection valve.

In the present invention, a coating layer for reducing frictional resistance is formed on an outer peripheral surface of the nozzle needle 30 colliding with the seat portion 26, in order not to cause the above problem.

As an example, the nozzle body 20 may be made of a material such as nickel-chrome-molybdenum steel (SNCM), the nozzle needle 30 may be made of a material such as high speed tool steel (SKH), and each frictional coefficient thereof may be constituted to be approximately 0.35 to 0.40, but the present invention is not limited thereto. Accordingly, the frictional resistance between the tip portion 32 and the seat portion 26 may be significantly reduced, compared to the related art, by forming the coating layer 36 on the tip portion 32 of the nozzle needle 30.

Meanwhile, the coating layers on the nozzle needle of the fuel injection valve according to the embodiment of the present invention are deposited by a sputtering process after a plasma state is formed by applying heat to an Ar gas, which is an inert gas injected into a vacuum chamber, at a high temperature.

That is, the vacuum chamber enters a plasma state therein when heat is applied to the Ar gas at a high temperature in the vacuum chamber, and an environment where particles for coating may be deposited is created while Ar particles collide with a base material in the above plasma state.

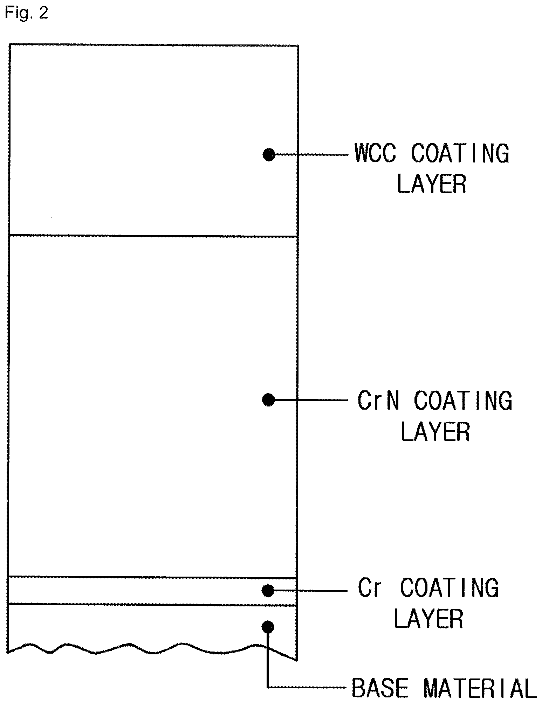

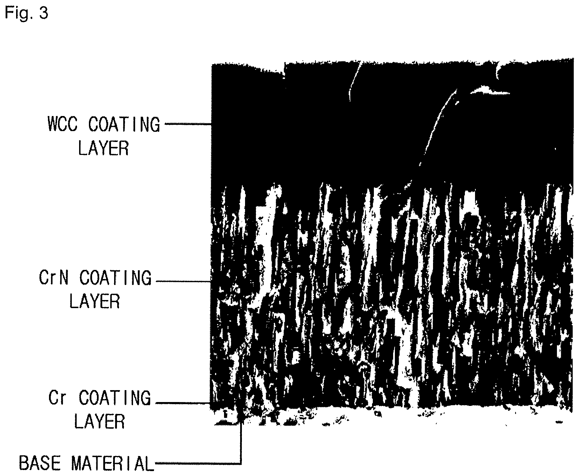

Figs. 2 and 3 illustrate a coating structure of the nozzle needle of the fuel injection valve according to the embodiment of the present invention.

Referring to Figs. 2 and 3, the coating structure of the nozzle needle of the fuel injection valve according to the embodiment of the present invention is comprised of a Cr coating layer formed over a base material of the nozzle needle, a CrN coating layer as an intermediate layer formed over the Cr coating layer, and a WCC coating layer formed over the CrN coating layer.

The Cr coating layer serves to improve adhesion between the base material (nozzle needle) and ceramic (CrN), and may be deposited over the base material of the nozzle needle by a sputtering method.

The CrN coating layer serves as the intermediate layer formed between the Cr coating layer and the WCC coating layer, and is deposited over the Cr coating layer for the purpose of enhancing the hardness of the nozzle needle and improving the impact resistance thereof,

For example, after Cr particles, which are separated from a Cr target by a plasma, react with N particles, which are separated from an N₂ gas injected as an activated gas, and CrN particles are formed, the CrN particles are deposited on a base material of the Cr coating layer to allow the CrN coating layer to be formed.

In addition, the WCC coating layer is deposited on an outer peripheral surface of the CrN coating layer. As such, since the WCC coating layer, which is formed on the outer peripheral surface of the nozzle needle of the fuel injection valve, has a solid lubrication effect, the WCC coating layer is less worn out even when continuously coming into contact with the seat portion.

For example, after WC particles, which are separated from a WC target by a plasma, react with C particles, which are separated from an acetylene (C₂H₂) gas injected as an activated gas, and WCC particles are formed, the WCC particles are deposited on a base material of the CrN coating layer to allow the WCC coating layer to be formed.

Meanwhile, in the coating structure of the nozzle needle of the fuel injection valve according to the embodiment of the present invention, the WCC coating layer formed on an outer peripheral surface of the CrN coating layer is formed to have a Vickers hardness of approximately 1300 HV, and the CrN coating layer formed as an intermediate layer is formed to have a Vickers hardness of approximately 1700 HV.

As such, since the CrN coating layer is formed to have a hardness relatively greater than a hardness of the WCC coating layer, an impulse arising from a collision between the nozzle needle and the seat portion may be effectively blocked from being transferred to the nozzle needle. Consequently, the deformation of the nozzle needle may be effectively prevented.

In addition, a coating layer of the nozzle needle of the fuel injection valve according to the embodiment of the present invention may be formed to have a thickness of approximately 1 µm to 5 µm. Here, the thickness of the coating layer represents a total thickness of the Cr coating layer, the CrN coating layer, and the WCC coating layer. Meanwhile, if the thickness of the coating layer is less than 1 µm, wear resistance and impact resistance may be deteriorated. Whereas if the thickness of the coating layer is more than 5 µm, the uniformity of coating quality may be deteriorated and coating costs may be unnecessarily increased.

As described above, when the coating layer is formed on the outer peripheral surface of the nozzle needle coming into contact with the seat portion, the tip portion of the nozzle needle 30 slides over the seat portion 26A in a state of low frictional resistance while being in contact with the seat portion 26A of the nozzle body 20 during a valve closing operation of the fuel injection valve.

Accordingly, the abrasion between the nozzle needle and the seat portion 26, which is generated during the valve closing operation, may be reduced compared to a case of not installing the coating layer. As a result, the fuel injection valve may be operated as required by fuel injection characteristics for a long time.

Next, a coating process of the nozzle needle of the fuel injection valve will be described.

First of all, the inside of the chamber in which the coating process is performed is formed in a vacuum state. This is for the purpose of improving the reaction rate of a gas.

After an Ar or He gas is injected as an inert gas into such a vacuum chamber, the inside of the chamber enters a plasma state by increasing the temperature thereof at a high temperature. Subsequently, the coating process is performed while the inside of the chamber is maintained in a temperature range of 200 to 280°C. In general, the fuel injection valve is operated by an electromagnetic force generated by an armature and a coil, and the coating layer of the nozzle needle may have soft magnetism in order for the fuel injection valve to be smoothly operated. Incidentally, if the inside of the chamber is out of the temperature range of 200 to 280°C, the coating layer formed on the nozzle needle does not have the soft magnetism.

Meanwhile, a bias voltage for the formation of the plasma may be in a range of 200 to 400 V. If the bias voltage is less than 200 V, a voltage for accelerating Ar ions drops, thereby allowing the hardness of the coating layer to be lowered. Whereas if the bias voltage is more than 400 V, a grid array becomes irregular, thereby enabling adhesion to be lowered.

After an etching process is performed to remove an oxidized layer and impurities formed on a nozzle surface of the fuel injection valve, the coating on the nozzle needle of the fuel injection valve is performed.

First, the Cr coating layer is formed on the outer peripheral surface of the nozzle needle of the fuel injection valve. For example, the Cr particles separated from the Cr target by the plasma are deposited on the base material of the nozzle needle to allow the Cr coating layer to be deposited.

Subsequently, the CrN coating layer is deposited on the outer peripheral surface of the Cr coating layer. For example, after the Cr particles, which are separated from the Cr target by the plasma, react with the N particles, which are separated from the N₂ gas injected as an activated gas, and the CrN particles are formed, the CrN particles are deposited on the base material of the Cr coating layer to allow the CrN coating layer to be formed.

Lastly, the WCC coating layer is deposited on the outer peripheral surface of the CrN coating layer. For example, after the WC particles, which are separated from the WC target by the plasma, react with the C particles, which are separated from the acetylene (C₂H₂) gas injected as an activated gas, and the WCC particles are formed, the WCC particles are deposited on the base material of the CrN coating layer to allow the WCC coating layer to be formed.

Although the present invention has been described with respect to the illustrative embodiments, it will be apparent to those skilled in the art that various variations and modifications may be made without departing from the scope of the invention as defined in the following claims. Various embodiments have been described in the best mode for carrying out the invention.

### INDUSTRIAL APPLICABILITY

In accordance with a nozzle coating structure and method of a fuel injection valve according to the present invention, wear resistance and impact resistance are improved by a coating layer formed on an outer peripheral surface of a nozzle needle. Consequently, an impulse arising from a collision between a tip portion of the nozzle needle and a seat portion is not transferred to the nozzle needle.

In addition, according to the present invention, since an intermediate CrN coating layer is constituted to have a hardness of greater than a hardness of an outer WCC coating layer, the wear resistance and the impact resistance may be further improved. Therefore, a change in fuel injection characteristics of the fuel injection valve as time elapses may be suppressed to be small, thereby being useful in improving the fuel injection valve.

## Claims

1. A nozzle coating structure of a fuel injection valve for reducing frictional resistance of a nozzle needle which comes into contact with a seat portion of a nozzle body formed with an injection hole, the nozzle coating structure comprising:
a Cr coating layer deposited on an outer peripheral surface of the nozzle needle of the fuel injection valve;
a CrN coating layer deposited on an outer peripheral surface of the Cr coating layer; and
a WCC coating layer deposited on an outer peripheral surface of the CrN coating layer,
wherein the CrN coating layer is formed to have a hardness relatively greater than a hardness of the WCC coating layer,
**characterized in that** each of the Cr coating layer, the CrN coating layer and the WCC coating layer has soft magnetism in order for the fuel injection valve to be smoothly operated.

2. The nozzle coating structure according to claim 1, wherein a total thickness of the Cr coating layer, the CrN coating layer, and the WCC coating layer is formed as 1 µm to 5 µm.

3. The nozzle coating structure according to claim 1, wherein the coating layers on the nozzle needle are deposited by a sputtering process in a plasma state caused by an Ar gas.

4. The nozzle coating structure according to any one of claims 1 to 3, wherein after Cr particles, which are separated from a Cr target by a plasma, react with N particles, which are separated from an N₂ gas injected as an activated gas, and CrN particles are formed, the CrN particles are deposited on a base material of the Cr coating layer to allow the CrN coating layer to be formed.

5. The nozzle coating structure according to any one of claims 1 to 3, wherein after WC particles, which are separated from a WC target by a plasma, react with C particles, which are separated from an acetylene (C₂H₂) gas injected as an activated gas, and WCC particles are formed, the WCC particles are deposited on a base material of the CrN coating layer to allow the WCC coating layer to be formed.

6. A nozzle coating method of a fuel injection valve for reducing frictional resistance of a nozzle needle which comes into contact with a seat portion of a nozzle body formed with an injection hole, the nozzle coating method comprising:
forming an inside of a chamber in a vacuum state so as to improve a reaction rate of a gas;
forming the inside of the chamber in a plasma state by increasing a temperature of the chamber after injecting an Ar gas into the chamber;
performing an etching process to remove an oxidized layer and impurities on a nozzle surface of the fuel injection valve;
depositing a Cr coating layer on an outer peripheral surface of the nozzle needle of the fuel injection valve;
depositing a CrN coating layer on an outer peripheral surface of the Cr coating layer; and
depositing a WCC coating layer on an outer peripheral surface of the CrN coating layer,
wherein the CrN coating layer is formed to have a hardness relatively greater than a hardness of the WCC coating layer, and
**characterized in that** each of the Cr coating layer, the CrN coating layer and the WCC coating layer has soft magnetism in order for the fuel injection valve to be smoothly operated.

7. The nozzle coating method according to claim 6, wherein the inside of the chamber entering the plasma state is maintained in a temperature range of 200 to 280°C.

8. The nozzle coating method according to claim 6, wherein a bias voltage for forming the plasma state is in a range of 200 to 400 V.

9. The nozzle coating method according to any one of claims 6 to 8, wherein after Cr particles, which are separated from a Cr target by a plasma, react with N particles, which are separated from an N₂ gas injected as an activated gas, and CrN particles are formed, the CrN particles are deposited on a base material of the Cr coating layer to allow the CrN coating layer to be formed.

10. The nozzle coating method according to any one of claims 6 to 8, wherein after WC particles, which are separated from a WC target by a plasma, react with C particles, which are separated from an acetylene (C₂H₂) gas injected as an activated gas, and WCC particles are formed, the WCC particles are deposited on a base material of the CrN coating layer to allow the WCC coating layer to be formed.

## Patentansprüche

1. Eine Düsenbeschichtungsstruktur eines Kraftstoffeinspritzventils zum Reduzieren des Reibungswiderstands einer Düsennadel, die mit einem Sitzabschnitt eines Düsenkörpers, der mit einem Einspritzloch gebildet ist, in Berührung gelangt, wobei die Düsenbeschichtungsstruktur folgende Merkmale aufweist:
eine Cr-Beschichtungsschicht, die auf einer Außenumfangsoberfläche der Düsennadel des Kraftstoffeinspritzventils abgeschieden ist;
eine CrN-Beschichtungsschicht, die auf einer Außenumfangsoberfläche der Cr-Beschichtungsschicht abgeschieden ist; und
eine WCC-Beschichtungsschicht, die auf einer Außenumfangsoberfläche der CrN-Beschichtungsschicht abgeschieden ist,
wobei die CrN-Beschichtungsschicht derart gebildet ist, dass dieselbe eine Härte aufweist, die relativ größer als eine Härte der WCC-Beschichtungsschicht ist,
**dadurch gekennzeichnet, dass** jede der Cr-Beschichtungsschicht, der CrN-Beschichtungsschicht und der WCC-Beschichtungsschicht einen weichen Magnetismus aufweist, so dass das Kraftstoffeinspritzventil problemlos bedient werden kann.

2. Die Düsenbeschichtungsstruktur gemäß Anspruch 1, bei der eine Gesamtdicke der Cr-Beschichtungsschicht, der CrN-Beschichtungsschicht und der WCC-Beschichtungsschicht so gebildet ist, dass dieselbe 1 µm bis 5 µm beträgt.

3. Die Düsenbeschichtungsstruktur gemäß Anspruch 1, bei der die Beschichtungsschichten auf der Düsennadel durch einen Sputtervorgang in einem Plasmazustand abgeschieden werden, der durch ein Ar-Gas bewirkt wird.

4. Die Düsenbeschichtungsstruktur gemäß einem der Ansprüche 1 bis 3, bei der, nachdem Cr-Partikel, die durch ein Plasma von einem Cr-Target getrennt werden, mit N-Partikeln reagieren, die von einem als aktiviertes Gas eingespritzten N₂-Gas getrennt werden, und CrN-Partikel gebildet werden, die CrN-Partikel auf einem Basismaterial der Cr-Beschichtungsschicht abgeschieden werden, damit die CrN-Beschichtungsschicht gebildet werden kann.

5. Die Düsenbeschichtungsstruktur gemäß einem der Ansprüche 1 bis 3, bei der, nachdem WC-Partikel, die durch ein Plasma von einem WC-Target getrennt werden, mit C-Partikeln reagieren, die von einem als aktiviertes Gas eingespritzten Acetylen(C₂H₂)-Gas getrennt werden, und WCC-Partikel gebildet werden, die WCC-Partikel auf einem Basismaterial der CrN-Beschichtungsschicht abgeschieden werden, um zu ermöglichen, damit die WCC-Beschichtungsschicht gebildet werden kann.

6. Ein Düsenbeschichtungsverfahren eines Kraftstoffeinspritzventils zum Reduzieren des Reibungswiderstands einer Düsennadel, die mit einem Sitzabschnitt eines Düsenkörpers, der mit einem Einspritzloch gebildet ist, in Berührung gelangt, wobei das Düsenbeschichtungsverfahren folgende Schritte aufweist:
Bilden eines Kammerinneren in einem Vakuumzustand, um eine Reaktionsgeschwindigkeit eines Gases zu verbessern;
Bilden des Kammerinneren in einem Plasmazustand, in dem eine Temperatur der Kammer erhöht wird, nachdem ein Ar-Gas in die Kammer eingespritzt wurde;
Durchführen eines Ätzvorgangs, um eine oxidierte Schicht und Verunreinigungen auf einer Düsenoberfläche des Kraftstoffeinspritzventils zu entfernen;
Abscheiden einer Cr-Beschichtungsschicht auf einer Außenumfangsoberfläche der Düsennadel des Kraftstoffeinspritzventils;
Abscheiden einer CrN-Beschichtungsschicht auf einer Außenumfangsoberfläche der Cr-Beschichtungsschicht; und
Abscheiden einer WCC-Beschichtungsschicht auf einer Außenumfangsoberfläche der CrN-Beschichtungsschicht,
wobei die CrN-Beschichtungsschicht derart gebildet ist, dass dieselbe eine Härte aufweist, die relativ größer als eine Härte der WCC-Beschichtungsschicht ist, und
**dadurch gekennzeichnet, dass** jede der Cr-Beschichtungsschicht, der CrN-Beschichtungsschicht und der WCC-Beschichtungsschicht einen weichen Magnetismus aufweist, so dass das Kraftstoffeinspritzventil problemlos bedient werden kann.

7. Das Düsenbeschichtungsverfahren gemäß Anspruch 6, bei dem das Kammerinnere, das in den Plasmazustand eintritt, bei einem Temperaturbereich von 200 bis 280 °C gehalten wird.

8. Das Düsenbeschichtungsverfahren gemäß Anspruch 6, bei dem eine Vorspannung zum Bilden des Plasmazustands in einem Bereich von 200 bis 400 V liegt.

9. Das Düsenbeschichtungsverfahren gemäß einem der Ansprüche 6 bis 8, bei dem, nachdem Cr-Partikel, die durch ein Plasma von einem Cr-Target getrennt werden, mit N-Partikeln reagieren, die von einem als aktiviertes Gas eingespritzten N₂-Gas getrennt werden, und CrN-Partikel gebildet werden, die CrN-Partikel auf einem Basismaterial der Cr-Beschichtungsschicht abgeschieden werden, damit die CrN-Beschichtungsschicht gebildet werden kann.

10. Das Düsenbeschichtungsverfahren gemäß einem der Ansprüche 6 bis 8, bei dem, nachdem WC-Partikel, die durch ein Plasma von einem WC-Target getrennt werden, mit C-Partikeln reagieren, die von einem als aktiviertes Gas eingespritzten Acetylen(C₂H₂)-Gas getrennt werden, und WCC-Partikel gebildet werden, die WCC-Partikel auf einem Basismaterial der CrN-Beschichtungsschicht abgeschieden werden, um zu ermöglichen, damit die WCC-Beschichtungsschicht gebildet werden kann.

## Revendications

1. Structure de revêtement d'un injecteur destiné à une soupape d'injection de carburant pour réduire la résistance à la friction d'une aiguille d'injecteur qui entre en contact avec une partie de siège d'un corps d'injecteur formé avec un trou d'injection, la structure de revêtement d'injecteur comprenant:
une couche de revêtement de Cr déposée sur une surface périphérique extérieure de l'aiguille d'injecteur de la soupape d'injection de carburant;
une couche de revêtement de CrN déposée sur une surface périphérique extérieure de la couche de revêtement de Cr; et
une couche de revêtement de WCC déposée sur une surface périphérique externe de la couche de revêtement de CrN,
dans lequel la couche de revêtement de CrN est formée de manière à présenter une dureté relativement supérieure à une dureté de la couche de revêtement de WCC,
**caractérisé par le fait que** la couche de revêtement de Cr, la couche de revêtement de CrN et la couche de revêtement de WCC présentent, chacune, un magnétisme doux pour que la soupape d'injection de carburant soit actionnée sans heurts.

2. Structure de revêtement d'injecteur selon la revendication 1, dans laquelle une épaisseur totale de la couche de revêtement de Cr, de la couche de revêtement de CrN et de la couche de revêtement de WCC est formée de manière à être de 1 µm à 5 µm.

3. Structure de revêtement d'injecteur selon la revendication 1, dans laquelle les couches de revêtement sur l'aiguille d'injecteur sont déposées par un processus de pulvérisation à l'état de plasma provoqué par un gaz Ar.

4. Structure de revêtement d'injecteur selon l'une quelconque des revendications 1 à 3, dans laquelle les particules de Cr qui sont séparées d'une cible de Cr par un plasma réagissent avec les particules de N qui sont séparées d'un gaz N₂ injecté sous forme de gaz activé et sont formées des particules de CrN, les particules de CrN sont déposées sur un matériau de base de la couche de revêtement de Cr pour permettre que soit formée la couche de revêtement de CrN.

5. Structure de revêtement d'injecteur selon l'une quelconque des revendications 1 à 3, dans laquelle les particules de WC qui sont séparées d'une cible de WC par un plasma réagissent avec les particules de C qui sont séparées d'un gaz d'acétylène (C₂H₂) injecté sous forme de gaz activé et sont formées des particules de WCC, les particules de WCC sont déposées sur un matériau de base de la couche de revêtement de CrN pour permettre que soit formée la couche de revêtement de WCC.

6. Procédé de revêtement d'un injecteur destiné à une soupape d'injection de carburant pour réduire la résistance à la friction d'une aiguille d'injecteur qui entre en contact avec une partie de siège d'un corps d'injecteur formé avec un trou d'injection, le procédé de revêtement d'injecteur comprenant le fait de:
former un intérieur d'une chambre à l'état de vide de manière à améliorer une taux de réaction d'un gaz;
former l'intérieur de la chambre à l'état de plasma en augmentant la température de la chambre après injection d'un gaz Ar dans la chambre;
effectuer un processus de gravure pour éliminer une couche oxydée et les impuretés sur une surface d'injecteur de la soupape d'injection de carburant;
déposer une couche de revêtement de Cr sur une surface périphérique extérieure de l'aiguille d'injecteur de la soupape d'injection de carburant;
déposer une couche de revêtement de CrN sur une surface périphérique extérieure de la couche de revêtement de Cr; et
déposer une couche de revêtement de WCC sur une surface périphérique extérieure de la couche de revêtement de CrN,
dans lequel la couche de revêtement CrN est formée de manière à présenter une dureté relativement supérieure à une dureté de la couche de revêtement de WCC, et
**caractérisé par le fait que** la couche de revêtement de Cr, la couche de revêtement de CrN et la couche de revêtement de WCC présentent, chacune, un magnétisme doux pour que la soupape d'injection de carburant soit actionnée sans heurts.

7. Procédé de revêtement d'injecteur selon la revendication 6, dans lequel l'intérieur de la chambre entrant à l'état de plasma est maintenu dans une plage de température de 200 à 280°C.

8. Procédé de revêtement d'injecteur selon la revendication 6, dans lequel une tension de polarisation pour former l'état de plasma se situe dans une plage de 200 à 400 V.

9. Procédé de revêtement d'injecteur selon l'une quelconque des revendications 6 à 8, dans lequel, après que les particules de Cr qui sont séparées d'une cible de Cr par un plasma réagissent avec les particules de N qui sont séparées d'un gaz N₂ injecté sous forme de gaz activé et que soient formées des particules de CrN, les particules de CrN sont déposées sur un matériau de base de la couche de revêtement de Cr pour permettre que soit formée la couche de revêtement de CrN.

10. Procédé de revêtement d'injecteur selon l'une quelconque des revendications 6 à 8, dans lequel, après que les particules de WC qui sont séparées d'une cible de WC par un plasma réagissent avec des particules de C qui sont séparées d'un gaz d'acétylène (C₂H₂) injecté sous forme de gaz activé et que soient formées des particules de WCC, les particules de WCC sont déposées sur un matériau de base de la couche de revêtement de CrN pour permettre que soit formée la couche de revêtement de WCC.
